# EUROPEAN PATENT APPLICATION

(11) **EP 1 939 936 A2**
(43) Date of publication of application: **02.07.2008**
(21) Application number: 07025026.1
(22) Date of filing: 21.12.2007
(51) Int. Cl.: H01L 23/427

(54) **Electronic component**

(30) Priority: 26.12.2006 JP 2006349795
(71) Applicant: SHINKO ELECTRIC INDUSTRIES CO., LTD., Nagano-shi, Nagano 381-2287 (JP)
(72) Inventor: Sunohara, Masahiro, Nagano-shi Nagano 381-2287 (JP); Shiraishi, Akinori, Nagano-shi Nagano 381-2287 (JP); Murayama, Kei, Nagano-shi Nagano 381-2287 (JP); Taguchi, Yuichi, Nagano-shi Nagano 381-2287 (JP); Koizumi, Naoyuki, Nagano-shi Nagano 381-2287 (JP); Higashi, Mitsutoshi, Nagano-shi Nagano 381-2287 (JP)
(74) Representative: Zimmermann, Gerd Heinrich

(57) **Abstract**

An electronic component has a substrate made of silicon in which a flow path for circulating a refrigerant is formed, a conductive pattern formed on a first principal surface of the substrate, a via plug penetrating the substrate and also connected to the conductive pattern, and an elastically deformable external connection terminal installed on a second principal surface of the substrate.

## Description

### BACKGROUND OF THE INVENTION

### 1. Field of the Invention

The present invention relates to an electronic component formed using a silicon substrate.

### 2. Description of Related Art

In a substrate (interposer) used in a package in which a semiconductor chip is mounted, a substrate formed using an organic material (resin material) is becoming mainstream instead of a substrate formed using a ceramic material. The substrate formed using the resinmaterial facilitates formation of a multilayer wiring structure or a fine shape as compared with the substrate formed using the ceramic material, and is suitable in the case of mounting a semiconductor chip miniaturized and highly integrated.

Also, with a speedup and an increase in performance of a semiconductor chip in recent years, the case where heat release of the semiconductor chip becomes a problem occurs. Because of this, packaging structures capable of efficiently performing heat dissipation and cooling have been proposed variously in order to package a semiconductor chip with a large heat release value (for example, see Japanese Patent Unexamined Publication JP-A-2005-12180).

However, a semiconductor chip mounted in a substrate is mainly constructed of silicon, so that there are cases where a difference between the semiconductor chip and the substrate in a thermal expansion coefficient becomes a problem particularly when a heat release value of the semiconductor chip is large.

For example, when the substrate is made of resin material, a large stress is applied to a portion of an electrical connection between the semiconductor chip and the substrate by the difference between the semiconductor chip and the substrate in a thermal expansion coefficient. As a result of this, there were cases where problems such as a decrease in a resistance value or a broken wire of the portion of electrical connection between the semiconductor chip and the substrate occur and reliability of the package decreases.

Also, there are cases where the problems of a decrease in a resistance value or a broken wire occurring between a substrate in which a semiconductor chip is mounted and a motherboard in which the substrate is mounted. For example, when a large difference between the substrate and the mother board in temperature occurs or when a difference between the substrate and the motherboard in a thermal expansion coefficient is large, there are cases where problems such as a decrease in a resistance value or a broken wire of the portion of electrical connection between the substrate and the motherboard occur.

### SUMMARY OF THE INVENTION

In view of the above, the overall problem of the invention is to provide a new and useful electronic component for solving the problems described above.

A concrete problemof the invention is to provide a reliable electronic component capable of mounting a high-performance semiconductor chip.

According to an aspect of the invention, there is provided an electronic component including:
a substrate made of Si and including a flow path for circulating refrigerant;
a conductive pattern formed on a first principal surface of the substrate;
a via plug penetrating the substrate and connected to the conductive pattern; and
an external connection terminal which is installed on a second principal surface of the substrate and is elastically deformable.

According to the invention, a reliable electronic component capable of mounting a high-performance semiconductor chip can be provided.

### BRIEF DESCRIPTION OF THE DRAWINGS

Fig. 1 is a sectional diagram schematically showing an electronic component according to a first embodiment;
Fig. 2 is a sectional diagram schematically showing an electronic component according to a second embodiment;
Fig. 3A is a first diagram showing a manufacturing method of the electronic component;
Fig. 3B is a second diagram showing a manufacturing method of the electronic component;
Fig. 3C is a third diagram showing a manufacturing method of the electronic component;
Fig. 3D is a fourth diagram showing a manufacturing method of the electronic component;
Fig. 3E is a fifth diagram showing a manufacturing method of the electronic component;
Fig. 3F is a sixth diagram showing a manufacturing method of the electronic component;
Fig. 3G is a seventh diagram showing a manufacturing method of the electronic component;
Fig. 3H is an eighth diagram showing a manufacturing method of the electronic component;
Fig. 3I is a ninth diagram showing a manufacturing method of the electronic component;
Fig. 3J is a tenth diagram showing a manufacturing method of the electronic component;
Fig. 4 is a first modified example of an external connection terminal;
Fig. 5 is a second modified example of the external connection terminal;
Fig. 6 is a third modified example of the external connection terminal; and
Fig. 7 shows an electronic component according to a modification of second embodiment.

### DETAILED DESCRIPTION OF THE PREFERED EMBODIMENTS

An electronic component according to the invention includes a substrate made of silicon and having a flow path for circulating refrigerant, a conductive pattern formed on a first principal surface of the substrate, a via plug penetrating the substrate and connected to the conductive pattern, and an external connection terminal which is installed on a second principal surface of the substrate and is elastically deformable.

In the electronic component, the substrate is formed of silicon. Accordingly, when a semiconductor chip mainly constructed of silicon is mounted on the substrate, a difference between the substrate and the semiconductor chip in a thermal expansion coefficient reduces. Therefore, fears of causing a decrease in a resistance value and a broken wire of the portion of electrical connection between the substrate and the semiconductor chip, etc. are reduced. As a result, an effect of improving reliability of connection is obtained.

In addition, in the electronic component, the flow path is formed in the substrate, so that the amount of cooling of the substrate is increased. Accordingly, temperature of the substrate is maintained low and further, the amount of cooling the semiconductor chip through the substrate can be increased. As a result of this, in the electronic component, occurrence of malfunction in the semiconductor chip due to heat generation is suppressed and also occurrence of a broken wire of the electrical connection portion resulting from thermal expansion is suppressed, and reliability improves.

Further, in the electronic component, the external connection terminal of the substrate deforms elastically. Accordingly, stress applied to the substrate, the external connection terminal, etc. resulting from a difference between the substrate and a motherboard, to which the substrate is mounted, in a thermal expansion coefficient is eased and reliability of connection between the substrate and the motherboard improves.

Next, a further concrete example of a configuration of the electronic component will hereinafter be described based on the drawings.

### [First embodiment]

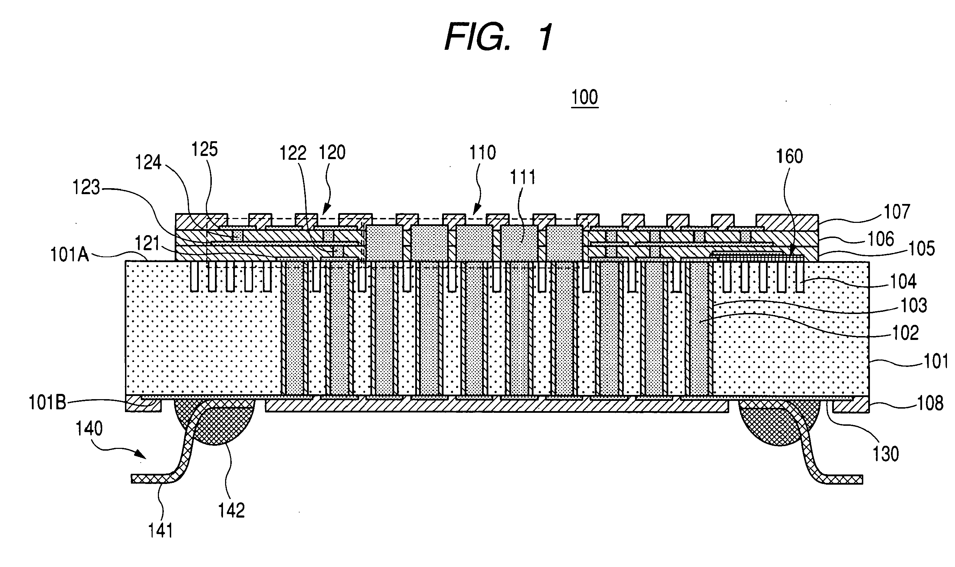

Fig. 1 is a sectional diagram schematically showing a configuration of an electronic component according to a first embodiment of the invention. Referring to Fig. 1, an electronic component 100 according to the present embodiment has a substrate (interposer) 101 made of silicon for mounting a semiconductor chip and respectively forming conductive patterns on a first principal surface 101A of the substrate 101 and a second principal surface 101B opposite to the first principal surface.

A power source system conductive pattern 110 formed in correspondence with the vicinity of a center of the mounted semiconductor chip; and a signal system conductive pattern 120 formed in correspondence with the peripheral edge of the semiconductor chip are formed on the first principal surface 101A, on which the semiconductor chip is mounted, of the substrate 101.
Power source system lines (a power source line, a ground line, etc.) of the semiconductor chip are connected to the power source system conductive pattern 110, and a signal line of the semiconductor chip is connected to the signal system conductive pattern 120.

Plural insulating layers 105, 106 made of an inorganic material such as SiO₂ are laminated on the first principal surface 101A, and at least parts of the conductive patterns 110, 120 are formed so as to be buried in the insulating layers 105, 106.

Also, the power source system conductive pattern 110 is constructed by plural conductive patterns (via plugs) 111 penetrating the plural insulating layers 105, 106 laminated on the first principal surface 101A. On the other hand, the signal system conductive pattern 120 is constructed by combination of plural pattern wirings and plural via plugs.

The signal system conductive pattern 120 constitutes the so-called multilayer wiring structure and includes:
the pattern wiring (conductive pattern 121) formed on the first principal surface 101A,
the via plug (conductive pattern 122) penetrating the insulating layer 105 and connected to the conductive pattern 121,
the pattern wiring (conductive pattern 123) formed on the insulating layer 105 and also connected to the conductive pattern 122,
the via plug (conductive pattern 124) penetrating the insulating layer 106 and connected to the conductive pattern 123, and
the pattern wiring (conductive pattern 125) formed on the insulating layer 106 and also connected to the conductive pattern 124.

Also, a solder resist layer (insulating layer) 107, in which openings for exposing at least parts of the conductive pattern 111 and the conductive pattern 125 are formed, is formed on the insulating layer 106. Flip chip bonding of a semiconductor chip mounted in the electronic component 100 is made to the conductive pattern 125 and the conductive patterns 111 exposed from the openings formed in the solder resist layer 107.

On the other hand, a conductive pattern 130 is formed on the second principal surface 101B of the substrate 101. Electrical connection between the conductive pattern 130 and the conductive pattern 121 and electrical connection between the conductive pattern 130 and the conductive pattern 111 are respectively made by via plugs 102 penetrating the substrate 101. Insulating films 103 made of, for example, a silicon oxide film are formed between the via plugs 102 and the substrate 101, and the substrate 101 is insulated from the via plugs 102. Also, insulating films formed between the conductive patterns 121, 111 and the substrate 101 or between the conductive pattern 130 and the substrate 101 are omitted in the drawing.

Also, a solder resist layer (insulating layer) 108 is formed so as to cover the second principal surface 101B, and an external connection terminal 140 is connected to the conductive pattern 130 exposed fromopenings formed in the solder resist layer 108. That is, the external connection terminal 140 formed on the side of the second principal surface 101B is configured to be connected to the conductive pattern formed on the side of the first principal surface through the conductive pattern 130 and the via plugs 102.

One of features of the electronic component 100 according to the embodiment described above is that the substrate 101 is made of silicon. As a result of this, when a semiconductor chip mainly constructed of silicon is mounted on the substrate 101, a difference between the substrate 101 and the semiconductor chip in a thermal expansion coefficient reduces. Therefore, fears of causing a decrease in a resistance value, a broken wire of the portion of electrical connection between the substrate 101 and the mounted semiconductor chip, etc. reduce, and an effect of improving reliability of connection is obtained.

Also, in the electronic component 100, a flow path 104 for circulating the refrigerant is formed in the substrate 101. As a result of this, the amount of cooling of the substrate 101 increases and a temperature of the substrate 101 is maintained low. In addition, the amount of cooling the semiconductor chip mounted through the substrate 101 can be increased. In consideration of the cooling efficiency, it is preferable that the respective flow path 104 is provided between the via plugs 102.

Therefore, in the electronic component 100, occurrence of the malfunction in the semiconductor chip due to heat generation is suppressed and also occurrence of a broken wire of the electrical connection portion resulting from thermal expansion of the mounted semiconductor chip or the substrate 101 is suppressed, and an effect of improving reliability is obtained.

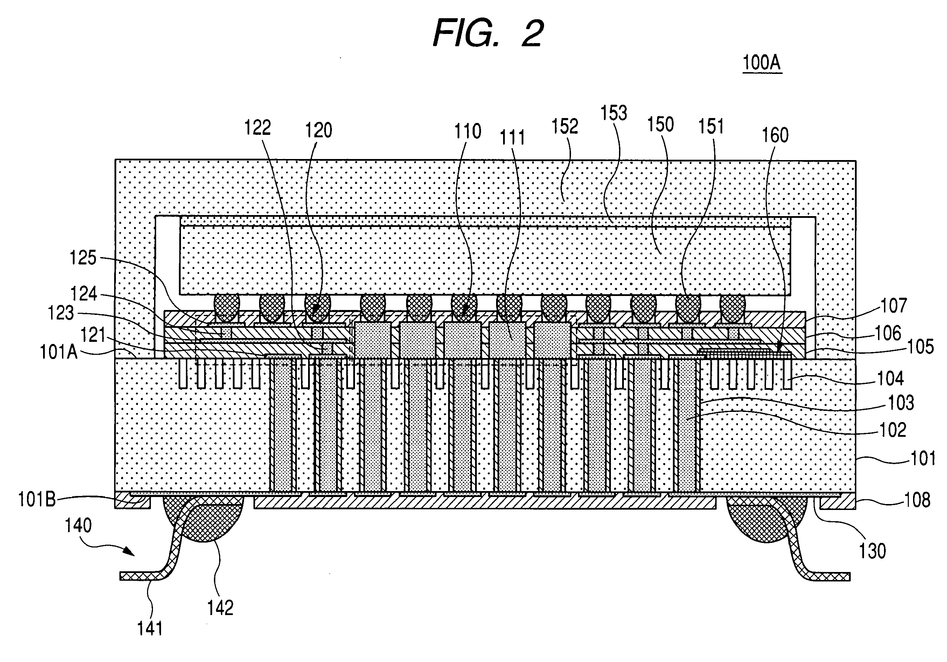

Also, in the electronic component 100 according to the embodiment, flip chip bonding of the semiconductor chip is performed face down with respect to the first principal surface 101A (described below in Fig. 2). That is, in the electronic component 100, the mounted semiconductor chip can be cooled from the side of a device surface and thus cooling efficiency of the mounted semiconductor chip improves.

Conventionally, it was a mainstream that a semiconductor chip is cooled from the back surface (the side opposite to a device surface). Generally, heat from the semiconductor chip is mainly generated in the side of the device surface in which a logic circuit etc. or multilayer wiring connected to the logic circuit etc. is formed. Thus, due to its structural limitation, it was difficult to form a cooling structure directly on the device surface or bring a cooling structure into direct contact with the device surface. As a result of this, in a conventional semiconductor apparatus, the semiconductor chip must be cooled from the back surface side and it became a problem in improving cooling efficiency.

On the other hand, in the electronic component 100 according to the embodiment, a semiconductor chip is connected so that a device surface corresponds to the substrate 101 cooled by the flow path 104 (see Fig. 2). As a result of this, a device formed in the chip, resulting in a main heat source of the semiconductor chip, can be cooled efficiently. Also, it is preferable to form the flow path 104 in the vicinity of the first principal surface 101A of the substrate 101 in order to more improve cooling efficiency of the semiconductor chip. For example, an opening of the flow path 104 formed in a channel shape may be constructed so as to be closed by the insulating layer 105. Also, when the flow path 104 is constructed so as to include the portion formed between the via plugs 102, cooling efficiency through the via plugs 102 improves and it is preferable.
As for the refrigerant, water, alcohol and fluorine based liquid are adaptable.

Also, one of the features of the structure described above is that, between the semiconductor chip and the substrate 101, a part of the heat transferring path also functions as an electrical connection. As a result of this, in the electronic component 100 according to the embodiment, the conductive patterns on the first principal surface 101A are formed as described below so as to be preferable respectively by the path of cooling and the path of electrical connection of the bonded semiconductor chip.

That is, an electrical resistance value of the power source system conductive pattern 110 formed in correspondence with the vicinity of the center of the mounted semiconductor chip is smaller than that of the signal system conductive pattern 120 formed in the peripheral edge of the semiconductor chip.
Also, the amount of heat dissipation from the power source system conductive pattern 110 to the substrate 101 is larger than the amount of heat dissipation from the signal system conductive pattern 120 to the substrate 101.

For example, the power source system conductive pattern 110 is constructed by the plural conductive patterns (via plugs) 111 penetrating the plural insulating layers 105, 106 laminated on the first principal surface 101A as described above. On the other hand, the signal system conductive pattern 120 is constructed by combination of plural pattern wirings and plural via plugs, and forms a multilayer wiring structure.

That is, the power source system conductive pattern 110 is constructed so that an electrical connection path from the mounted semiconductor chip to the first principal surface 101A becomes shorter than that of the signal system conductive pattern 120. As a result of this, an electrical resistance value of the power source system conductive pattern 110 becomes smaller than that of the signal system conductive pattern 120. Also, a cross-sectional area (area of the case of being viewed from the plane) of the power source system conductive pattern 110 is larger than that of the signal system conductive pattern 120. Also, in this respect, a resistance value of the power source system conductive pattern 110 becomes small. Further, by being constructed as described above, the amount of heat dissipation from the power source system conductive pattern 110 to the substrate 101 in the case of cooling the mounted semiconductor chip becomes larger than the amount of heat dissipation from the signal system conductive pattern 120 to the substrate 101.

Generally, when a semiconductor chip produces heat, the vicinity of the center is resistant to being cooled than the peripheral edge and temperature of the vicinity of the center tends to become higher than that of the peripheral edge, so that the structure described above is preferable in the case of improving cooling efficiency of the semiconductor chip.

Diameters (widths) of the conductive patterns (via plugs) 111 constructing the power source system conductive pattern 110 are formed in, for example, about 10 to 100 µm. On the other hand, widths of the conductive patterns (pattern wirings) 121, 123 constructing the signal system conductive pattern 120 are formed in about 1 to 5 µm. Also, diameters of the conductive patterns (via plugs) 122, 124 constructing the signal system conductive pattern 120 are formed in about 3 µm.

Also, it is preferable to form the insulating layers (interlayer insulating layers) 105, 106 in which the conductive patterns 110, 120, etc. are formed by, for example, SiO₂. Since a withstand voltage value of SiO₂ is higher than that of resin material, the insulating layers 105, 106 can be thinned.
For example, when the interlayer insulating layer is constructed of resin material, a thickness of one layer was about 30 to 40 µm, but when SiO₂ is used, a thickness of one layer of the interlayer insulating layers can be thinned to about 1 µm. Also, SiO₂ facilitates microfabrication, so that miniaturization of a multilayer wiring structure formed is facilitated as compared with the case using the resin material. Also, the insulating layers 105, 106 can be formed using the resin material according to the wiring structure formed.

Also, in the electronic component 100 according to the embodiment, the external connection terminal 140 installed on the side of the second principal surface of the substrate 101 is elastically deformable. For example, the external connection terminal 140 is constructed by a connection terminal 141 formed by folding a band-like or linear elastic body, and joining means (solder) 142 for connecting the connection terminal 141 to the conductive pattern 130.

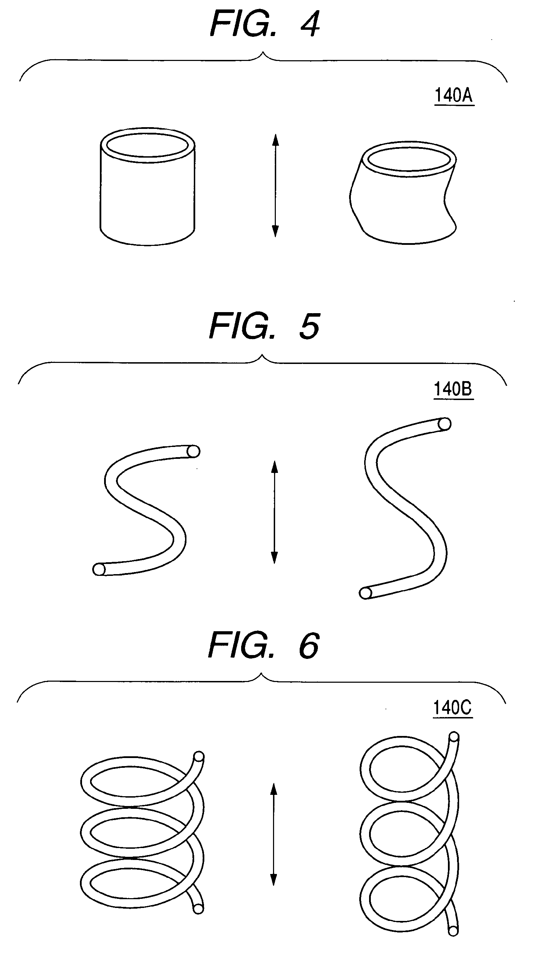

The connection terminal 141 is constructed by, for example, folding both ends of a band-like or linear elastic body in different directions. Also, the shapes of the connection terminal 141 or the folding directions of the connection terminal 141 are not limited to the case shown in the present drawings, and may be modified and changed variously (described below in Fig. 4).

When the electronic component 100 according to the embodiment is mounted in, for example, a motherboard, one end opposite to the end connected to the conductive pattern 130 of the connection terminal 141 could be connected to an electrode pad etc. of the motherboard.

In the electronic component 100, because the external connection terminal 140 is elastically deformable, stress applied to the substrate 101 or the external connection terminal 140 is eased and reliability of electrical connection between the substrate 101 and the motherboard improves.

In the construction described above, the substrate 101 is made of silicon, so that there is a fear that a difference in a thermal expansion coefficient between the substrate 101 and the motherboard formed by resin material increases while a difference between the substrate 101 and the mounted semiconductor chip in a thermal expansion coefficient decreases.

Therefore, in the electronic component according to the embodiment, stress resulting from a difference between the substrate 101 and the motherboard in thermal expansion is eased by the external connection terminal 140.

That is, in the electronic component 100 of the invention, both of the reliability of electrical connection between the substrate 101 and the mounted semiconductor chip and the reliability of electrical connection between the substrate 101 and the motherboard improve.

Also, for example, in the electronic component 100, a passive element may be formed so that at least a part of the passive element is buried in the insulating layer 105 or the insulating layer 106 constructing a multilayer wiring structure. For example, when the insulating layer 105, 106 is constructed by SiO₂, it becomes easy to incorporate the passive element into the multilayer wiring structure and it is preferable. In the embodiment, a passive element 160 made of, for example, a capacitor is formed on the first principal surface 101A so as to be connected to the conductive pattern 121 and the passive element 160 is configured to be covered with the insulating layer 105.

For example, in order to thin the capacitor, it is preferable that a dielectric constant of a dielectric layer used in the capacitor be high. However, there was a problem that a formed temperature is high (for example, about 800 °C) in the so-called high-dielectric constant materials such as BST or PZT with a high dielectric constant. As a result of this, when an insulating layer is made of resin material, it was difficult to use these high-dielectric constant materials. However, by constructing an insulating layer of SiO₂, the capacitor can be formed using such high-dielectric constant materials and the capacitor can be thinned.

Also, the passive element is thinned, so that the passive element can be installed on the side of the first principal surface 101A, and a path of connection between the passive element and the mounted semiconductor chip can be shortened.

Also, one example of a concrete configuration of the electronic component 100 could be set as described below. However, the following numerical values or materials are one example and the invention is not limited to this example.

It is constructed so that, for example, thickness of the substrate 101 is 200 to 500 µm and thickness of the insulating layer 105, 106 is 1 to 2 µm and a diameter of the via plug 102 is 10 to 20 µm and a pitch at which the via plug 102 is installed is 20 to 40 µm. The via plug 102 and the conductive patterns 111, 121 to 125, 130 are formed by, for example, Cu.

### [Second embodiment]

Also, Fig. 2 is a diagram schematically showing an electronic component (semiconductor device) 100A made by mounting a semiconductor chip 150 on the electronic component 100 according to the first embodiment. However, in the following diagram, the same numerals are assigned to the portions described above and the description is omitted (similar matters apply to the following embodiments).

Referring to Fig. 2, in the electronic component 100A according to the present embodiment, flip chip bonding of the semiconductor chip 150 is performed face down so that a device surface corresponds to a substrate 101 cooled by a flow path 104. For example, flip chip bonding of the semiconductor chip 150 is made to conductive patterns 111, 125 exposed from openings formed in a solder resist layer 107 through bumps 151.

Also, in the electronic component 100A according to the embodiment, a stiffener 152 is installed on the substrate 101. For example, when the stiffener 152 is joined to the peripheral edge of the substrate 101 with a quadrangle in the case of being viewed from the plane, warpage of the substrate 101 is suppressed and it is preferable.
For example, when the stiffener 152 is made of silicon, the stiffener 152 can be directly joined to the substrate 101 made of silicon and it is preferable. Also, when both of the stiffener 152 and the substrate 101 are made of silicon, a difference between the stiffener and the substrate in a thermal expansion coefficient decreases and it is preferable.

Also, the stiffener 152 may be constructed so as to have a surface corresponding to the semiconductor chip 150 and join the surface corresponding to the semiconductor chip 150 to the semiconductor chip 150 by a joining material 153. That is, the stiffener 152 may be constructed so as to be joined to both of the substrate 101 and the semiconductor chip 150. In this case, the semiconductor chip 150 is cooled by the substrate 101 (flow path 104) through the stiffener 152.

The stiffener 152 has both of a function of suppressing warpage of the substrate 101 and a function of cooling the semiconductor chip 150 as a heat spreader.

Also, a material constructing the stiffener (heat spreader) is not limited to silicon, and the stiffener may be constructed using other materials such as a metal material (Cu, Al or etc.).

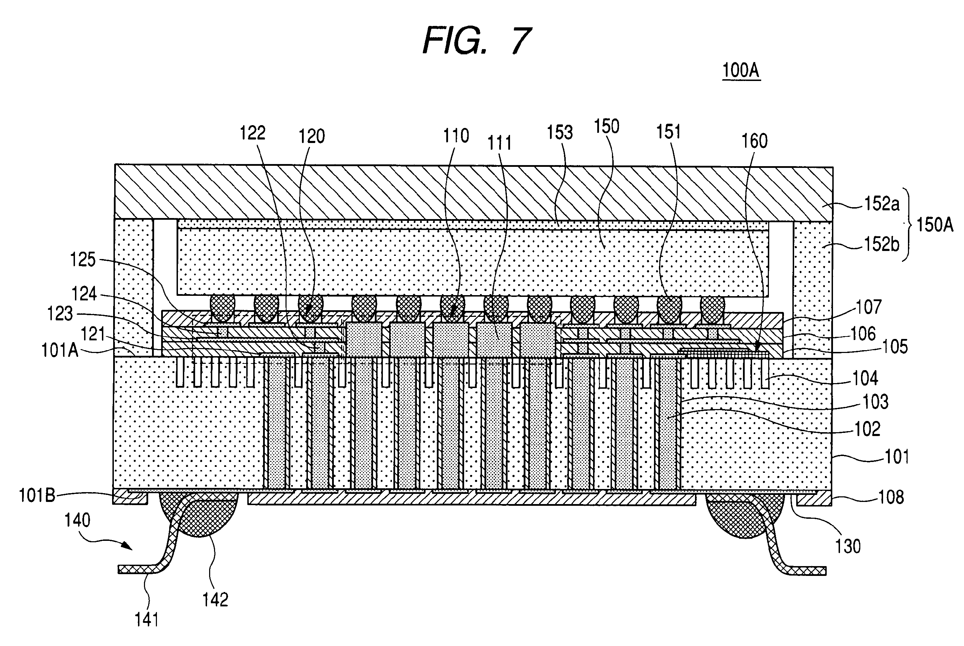

Although the stiffener 152 as shown in Fig. 2 is integrally provided, the stiffener 152 may have a separated structure. That is, as shown in Fig.7, the stiffener 152A has a top plate 152a contacting with the semiconductor chip 150 and a joint frame 152b which is provided between the top plate 152a and the substrate 101 so as to surround the conductive patterns 121 through 125 and joins the top plate 152a to the substrate 101.
In this modified embodiment, the joint frame 152b is preferably made of Si. Because the substrate 101 is made of Si, it is desirable that the difference in the thermal expansion coefficient between the substrate 101 and the joint frame 152b is small.
Further, the top plate 152a may be made of Si or metal such as Cu or Al. In addition to the function of preventing warpage of the substrate 101, the top plate 152a also functions as transferring the heat from the semiconductor chip 150 to the substrate 101 provided with the flow path 104 via the joint frame 152. Thus, in order to effectively transfer the heat, the top plate 152a may be made of metal having good thermal conductivity. In view of this aspect, similar to the embodiment shown in Fig. 2, it is acceptable that the joining material 153 may be provided between the top plate 152a and the semiconductor chip 150.

### [Third embodiment]

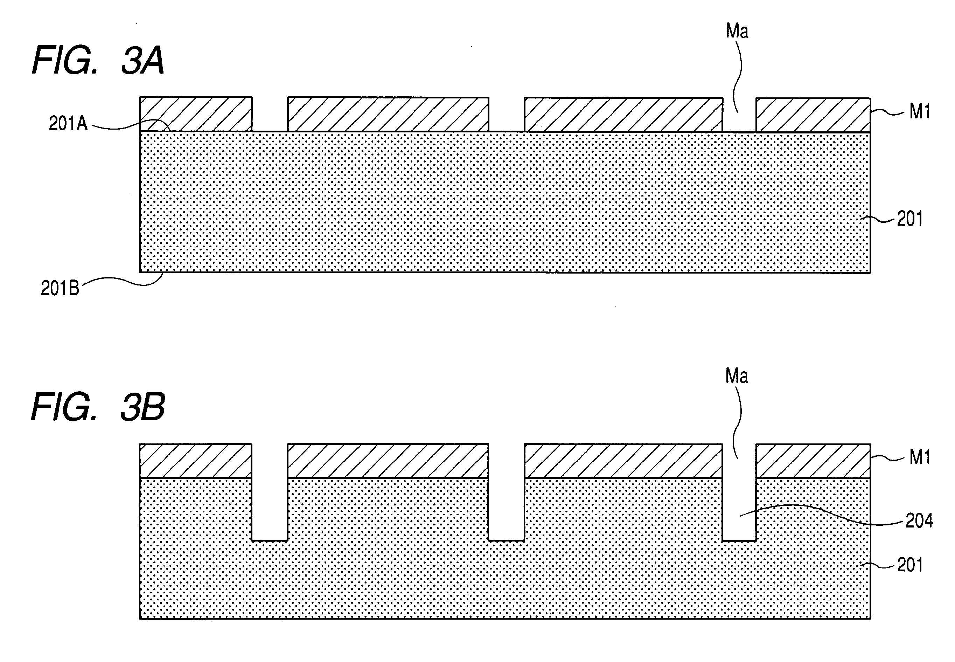

Next, one example of a manufacturing method for manufacturing the electronic component according to the first embodiment (second embodiment) will be described by following procedures based on Figs. 3A to 3J.

First, in a step shown in Fig. 3A, a resist pattern M1 having openings Ma is formed on a first principal surface 201A (corresponding to the first principal surface 101A) of a substrate 201 (corresponding to the substrate 101) made of silicon. The resist pattern M1 is formed by patterning a resist layer formed by pasting of a resist on a film or application of a liquid resist by a photolithography method. In addition, a second principal surface 201B (corresponding to the second principal surface 101B) is formed on the side opposite to the first principal surface 201A of the substrate 201.

Next, in a step shown in Fig. 3B, using the mask pattern M1 as a mask, the substrate 201 is etched by, for example, RIE (reactive ion etching) and a flow path 204 (corresponding to the flow path 104) for circulating a refrigerant is formed.

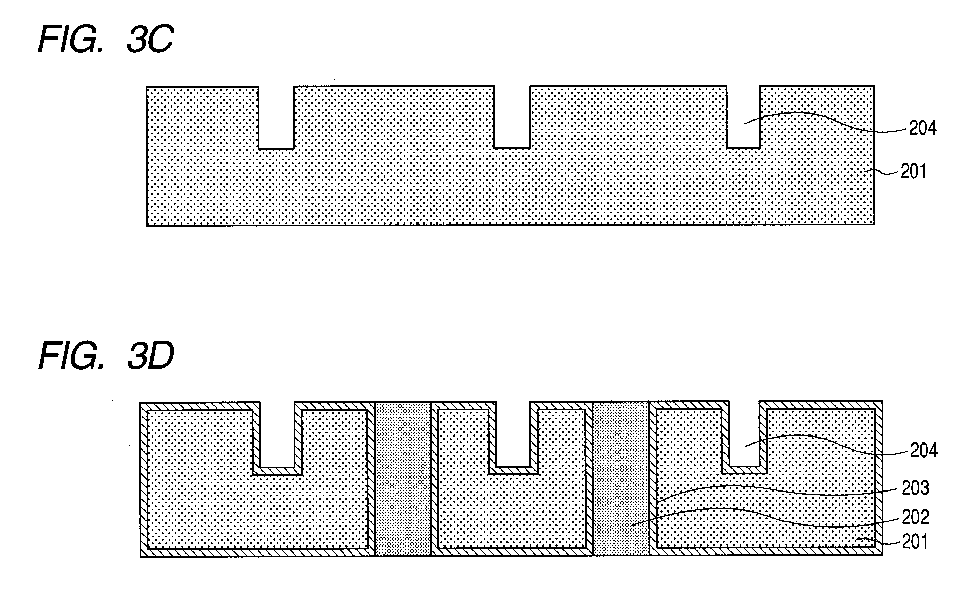

Then, in a step shown in Fig. 3C, the mask pattern M1 is peeled.

Then, in a step shown in Fig. 3D, in a manner similar to the steps shown in Figs. 3A to 3C, via holes penetrating the substrate 201 are formed and via plugs 202 (corresponding to the via plugs 102) for burying the via holes are formed by a well known Cu plating method. Also, it is preferable to form an insulating film (SiO₂) on a surface of the substrate 201 by thermal oxidation prior to formation of the via plugs 202 after forming the via holes.

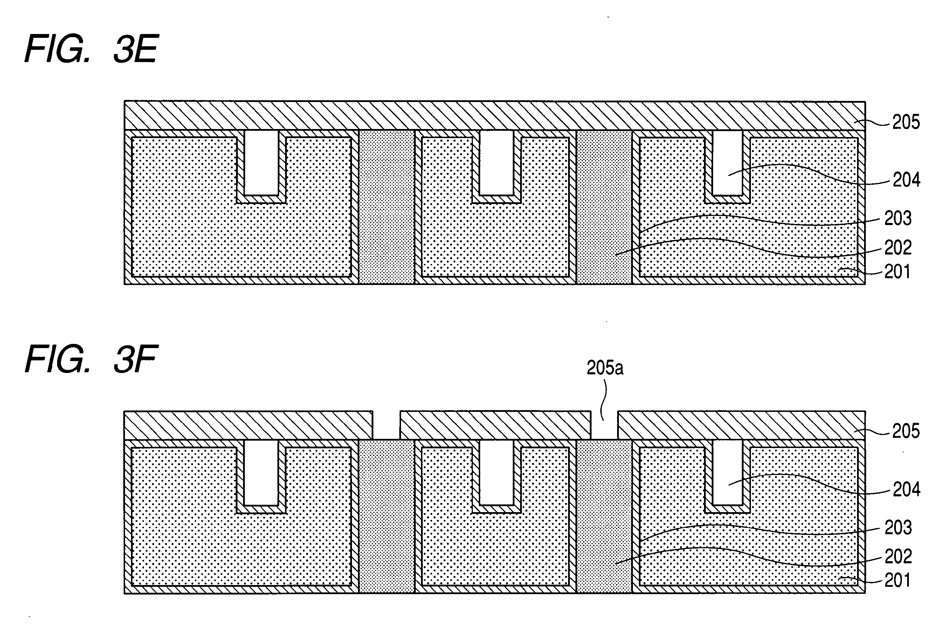

Then, in a step shown in Fig. 3E, an insulating layer 205 (corresponding to the insulating layer 105) is formed on the first principal surface of the substrate 201 so as to close openings of the flow path 204 formed in a channel shape. For example, in the insulating layer 205, an insulating layer made of SiO₂ may be formed by a CVD (Chemical Vapor Deposition) method or an insulating layer made of resin material such as epoxy may be formed by laminate.

For example, when the insulating layer 205 is formed by the CVD method, the insulating layer 205 can be formed so as to close the openings of the flow path 204 by performing CVD by a condition that coverage becomes worse so that SiO₂ does not flow in the inside of the flow path 204 where possible.

Also, when the insulating layer 205 is formed by the laminate of a film-shaped resin, the insulating layer 205 can be formed by pasting a partially cured film-shaped resin on the substrate 201 using a roll laminator and further heating and curing (substantially completely curing) the resin after pasting.

Then, in a step shown in Fig. 3F, using a mask pattern (not shown), the insulating layer 205 made of SiO₂ is etched by RIE and openings 205a are formed and parts of the via plugs 202 are exposed from the openings 205a. Also, when the insulating layer 205 is made of resin material, the openings 205a are formed by laser.

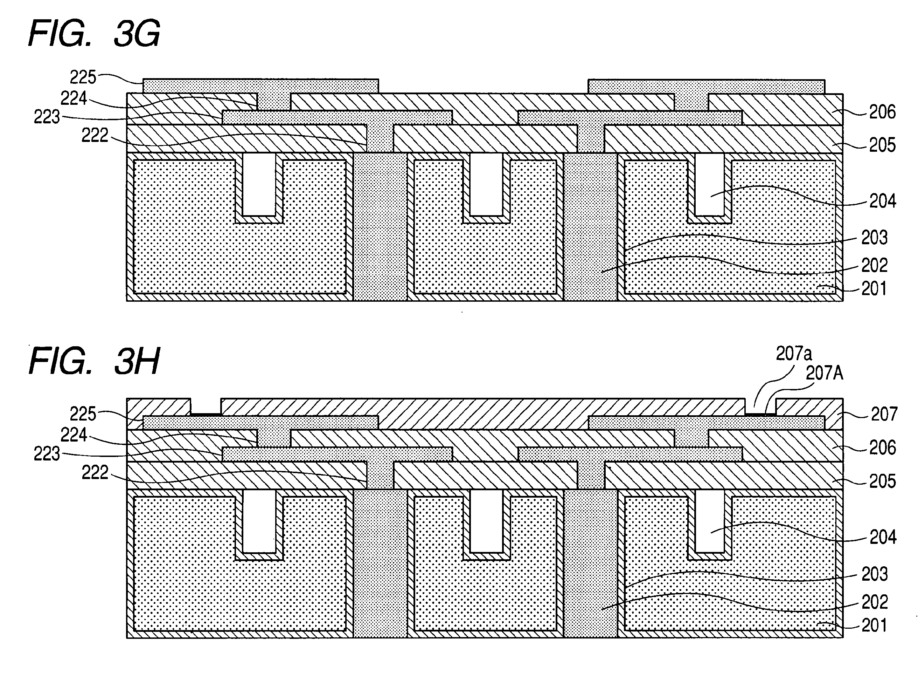

Then, in a step shown in Fig. 3G, conductive patterns (via plugs) 222 (corresponding to the conductive pattern 122) for burying the openings 205a and a conductive pattern (pattern wiring) 223 (corresponding to the conductive pattern 123) connected to the conductive patterns 222 and also formed on the insulating layer 205 are formed by a well known semi-additive method.

Also, steps similar to the steps of Figs. 3E to 3F are further performed and an insulating layer 206 (corresponding to the insulating layer 106) for covering the conductive pattern 223 is formed and openings are formed in the insulating layer 206. Then, conductive patterns (via plugs) 224 (corresponding to the conductive pattern 124) for burying the openings and a conductive pattern (pattern wiring) 225 (corresponding to the conductive pattern 125) connected to the conductive patterns 224 and also formed on the insulating layer 206 are again formed by the well known semi-additive method.

Then, in a step shown in Fig. 3H, a solder resist layer 207 (corresponding to the solder resist layer 107) is formed so as to cover the insulating layer 206 and the conductive pattern 222. Also, openings 207a are formed in the solder resist layer 207 so that a part of the conductive pattern 225 is exposed.

Also, a connection layer 207a made of a laminated structure of, for example, an Ni layer and an Au layer may be formed on the conductive pattern 225 exposed from the openings 207a.

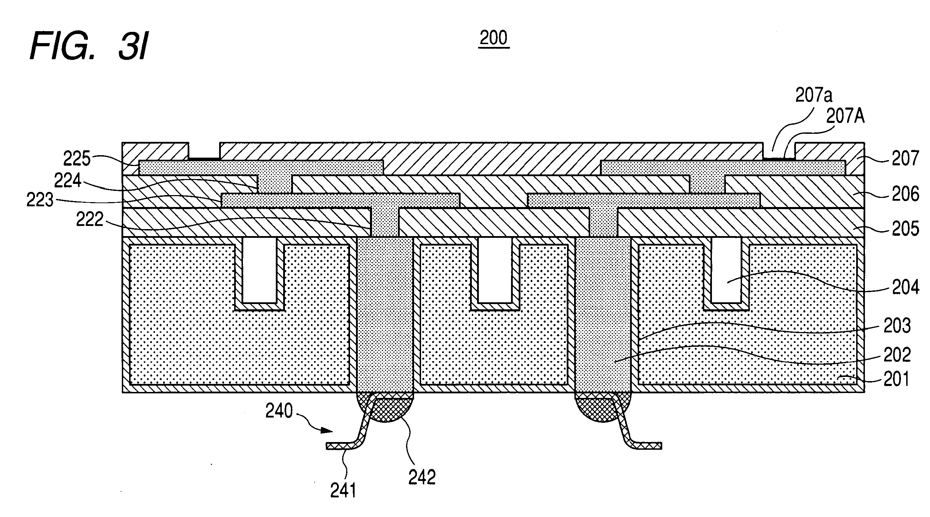

Then, in a step shown in Fig. 3I, a connection terminal 241 (corresponding to the connection terminal 141) constructed by, for example, folding both ends of a band-like or linear elastic body in different directions is connected to the via plugs 202 by joining means 242 (corresponding to the joining means 142) and an external connection terminal 240 (corresponding to the external connection terminal 140) is formed.

In this manner, an electronic component 200 (corresponding to the electronic component 100) can be formed. In addition, the electronic component 200 according to the embodiment has a construction in which the conductive patterns 111, 121, 130, etc. of the electronic component 100 are omitted, but the construction of the conductive patterns may be modified and changed variously. Also, the external connection terminal 240 installed on the second principal surface side is directly connected to the via plugs 202 penetrating the substrate 201 rather than the conductive pattern in the case of the embodiment, but may be constructed by omitting a conductive pattern formed on the second principal surface as described in the embodiment.

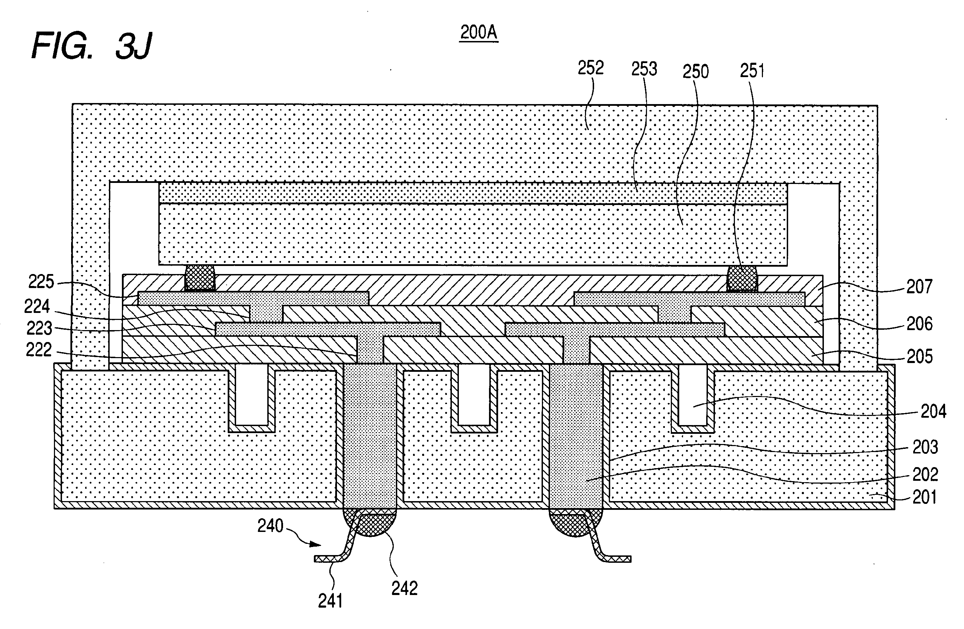

Also, a step shown in Fig. 3J is further performed and a semiconductor chip may be mounted on the electronic component described above.

For example, in the step shown in Fig. 3J, flip chip bonding of a semiconductor chip 250 is made to the conductive pattern 225 through bumps 251.

Further, a stiffener 252 (corresponding to the stiffener 152) made of, for example, silicon may be joined on the substrate 201. Also, a surface corresponding to the semiconductor chip 250 of the stiffener 252 may be constructed so as to be joined to the semiconductor chip 250 by a joining material 253 in a manner similar to the case of the second embodiment (electronic component 100A).

In this manner, an electronic component 200A (corresponding to the electronic component 100A) made by mounting the semiconductor chip 250 on the electronic component 200 can be manufactured.

Also, when a passive element such as a capacitor is formed on the first principal surface of the substrate, it could be constructed as described below. Electrodes (an upper electrode and a lower electrode) of the capacitor can be formed by a method similar to that of the conductive pattern. Also, when a high-dielectric layer of the capacitor is formed, the following two methods can be formed mainly. For example, the high-dielectric layer can be formed by curing at about 800 °C and pattern etching after PZT or BST is applied by spin coat. Also, the high-dielectric layer can be formed by pattern etching after a PZT or BST film is formed by an aerosol deposition method.

### [Fourth embodiment]

Also, an elastically deformable external connection terminal which is installed on an electronic component is not limited to the shape (structure) described in the embodiments, and can be modified and changed variously, for example, as described below.

Figs. 4 to 6 are diagrams schematically showing modified examples of the external connection terminals installed on the electronic component. However, in the following diagrams, joining means for joining a connection terminal such as solder is omitted.

The external connection terminal 140A may be constructed by a cylindrical elastic body as shown in Fig. 4. In this case, the external connection terminal 140A contracts in a buckling direction.

Also, the external connection terminal 140B, 140C may be, for example, an S-shaped elastic body as shown in Fig. 5 or a swirl (spiral) elastic body as shown in shown in Fig. 6.

Also, the elastic body is not limited to the shapes (structures) described above, and may be changed variously according to specifications and structures of a substrate or a motherboard.

The invention has been described above with reference to the preferred embodiments, but the invention is not limited to the specific embodiments described above, and various modifications and changes can be made within the gist described in the claims.

For example, as the insulating layers (insulating layers 105, 106, 205, 206, etc.) formed on the substrate, inorganic materials other than SiO₂ may be used and, for example, SiN (siliconnitride film) ormaterials inwhichC (carbon), nitrogen (N), etc. are added to SiO₂ may be used. Also, a material constructing the conductive pattern or the via plug is not limited to Cu, and metals such as Al, W, Ti or Ta, nitride of these metals, or alloy materials including these metals may be used.

According to the invention, a reliable electronic component capable of mounting a high-performance semiconductor chip can be provided.

## Claims

1. An electronic component comprising:
a substrate made of Si and comprising a flow path for circulating refrigerant;
a conductive pattern formed on a first principal surface of the substrate;
a via plug penetrating the substrate and connected to the conductive pattern; and
an external connection terminal which is installed on a second principal surface of the substrate and is elastically deformable.

2. The electronic component as claimed in claim 1, wherein
an insulating layer is formed on the first principal surface and
the conductive pattern forms a multilayer wiring structure together with the insulating layer.

3. The electronic component as claimed in claim 2, wherein the insulating layer includes SiO₂ or organic resin.

4. The electronic component as claimed in claim 2 or 3, wherein
a passive element is formed in the multilayer wiring structure.

5. The electronic component as claimed in one of the claims 1 to 4, further comprising:
a stiffener which is made of Si and is joined to the substrate.

6. The electronic component as claimed in one of the claims 1 to 5, wherein
there are provided a plurality of the conductive patterns,
the plurality of the conductive patterns comprise:
a power source system conductive pattern formed in correspondence with a vicinity of a center of a semiconductor chip mounted on the first principal surface side; and
a signal system conductive pattern formed in correspondence with a peripheral edge of the semiconductor chip,
an electrical resistance value of the power source system conductive pattern is smaller than that of the signal system conductive pattern and
the amount of heat dissipation from the power source system conductive pattern to the substrate is larger than the amount of heat dissipation from the signal system conductive pattern to the substrate.

7. The electronic component as claimed in one of the claims 1 to 6, further comprising a semiconductor chip which is flip chip bonded on the conductive pattern.

8. The electronic component as claimed in claim 7, further comprising a stiffener joined to the substrate and the semiconductor chip,
wherein the semiconductor chip is cooled through the stiffener.

9. The electronic component as claimed in one of the claims 1 to 8, further comprising:
a semiconductor chip mounted on the conductive pattern; and
a stiffener comprising:
a top plate contacting with the semiconductor chip; and
a joint frame which is provided between the top plate and the substrate so as to surround the conductive pattern and joins the top plate to the substrate,
wherein the top plate is made of Si or metal, and
the joint frame is made of Si.

10. The electronic component as claimed in claim 9, wherein
the top plate contacts with the semiconductor chip via a joining material.

11. The electronic component as claimed in one of the claims 1 to 10, wherein
the flow path is provided between the via plugs.
